# EUROPÄISCHE PATENTANMELDUNG

(11) **EP 3 182 813 A1**
(43) Veröffentlichungstag der Anmeldung: **21.06.2017**
(21) Anmeldenummer: 16203250.2
(22) Anmeldetag: 09.12.2016
(51) Int. Cl.: H05K 7/20, H02M 7/00

(54) **UMRICHTERKÜHLSYSTEM**

(30) Priorität: 18.12.2015 DE 202015106919 U
(71) Anmelder: ABB Technology Oy, 00380 Helsinki (FI)
(72) Erfinder: Zumsteg, Marc, 5272 Oberhofen (CH)
(74) Vertreter: ABB Patent Attorneys

(57) **Zusammenfassung**

Es wird ein Umrichterkühlsystem zur Kühlung mittels eines Kühlfluids angegeben, welches Umrichterkühlsystem einen Wärmetauscher (1) und einem parallel zu dem Wärmetauscher (1) vorgesehenen Kühlfluidbypasspfad (2) aufweist, wobei ein der Regulierung der Kühlfluidmenge dienendes Regulierungsventil (3) einen ersten Verbindungspunkt (4) bildet, an dem der Kühlfluidbypasspfad (2) mit dem Wärmetauscher (1) verbunden ist, und wobei der Kühlfluidbypasspfad (2) mit dem Wärmetauscher (1) an einem zweiten Verbindungspunkt (5) verbunden ist. Desweiteren ist eine Pumpeinheit (6) zur Zirkulation des Kühlfluids, wobei eine Ausgangsseite der Pumpeinheit (6) mit dem ersten Verbindungspunkt (4) verbunden ist. Zudem umfasst das Umrichterkühlsystem einen Filterpfad (7), der an einem dritten Verbindungspunkt (8) mit einer Eingangs-seite der Pumpeinheit (6) verbunden ist und der mit dem zweiten Verbindungspunkt (5) verbunden ist, wobei im Filterpfad (7) eine Filtereinheit (9) vorgesehen ist, mit einem Kühlfluidzulaufpfad (10), der mit dem dritten Verbindungspunkt (8) verbunden ist. Ferner ist ein Kühlfluidablaufpfad (11) mit dem vierten Verbindungspunkt (12) verbunden, wobei im Kühlfluidzulaufpfad (10) und/oder im Kühlfluidablaufpfad (11) eine Temperaturerfassungseinheit (13) und eine Druckerfassungseinheit (14) vorgesehen sind, und wobei eine Kühlfluidleckageauffangeinrichtung vorgesehen ist, die einen Leckagedetektor aufweist.

## Beschreibung

### Technisches Gebiet

Die vorliegende Erfindung bezieht sich auf das Gebiet der Kühltechnik für Umrichterschaltungen. Sie betrifft ein Umrichterkühlsystem gemäss dem Oberbegriff des unabhängigen Anspruchs.

### Stand der Technik

Umrichterschaltungen mit Leistungshalbleiterschaltern werden heute in vielerlei Anwendungen eingesetzt. Die Leistungshalbleiterschalter werden über Kühlelemente gekühlt, durch das ein Kühlfluid strömt. Als Kühlelement werden beispielsweise Kühldosen verwendet, wobei als Kühlfluid üblicherweise deionisiertes Wasser eingesetzt wird. Die Kühldosen sind typischerweise an den Fluidkreislauf eines Umrichterkühlsystems angeschlossen, welches dazu einen Zulaufpfad und einen Ablaufpfad aufweist.

Problematisch bei einem Umrichterkühlsystem sind beispielsweise Temperatur- und Druckschwankungen, die oft zu spät oder gar nicht erst erkannt werden. Solche Einflüsse belasten das Umrichterkühlsystem sowie die gekühlten Leistungshalbleiterschalter stark, lassen Komponenten früher altern und erhöhen den Wartungsaufwand und damit die laufenden Kosten. Desweiteren können solche Einflüsse das Umrichterkühlsystem beschädigen oder gar zerstören.

In der DE 102012112932 A1 und der DE 112007002875 B4 ist jeweils ein Kühlsystem zur Kühlung mittels eines Kühlfluids, insbesondere für einen Umrichter, angegeben.

### Darstellung der Erfindung

Aufgabe der Erfindung ist es deshalb, ein Umrichterkühlsystem anzugeben, welches robust aufgebaut ist. Diese Aufgabe wird durch die Merkmale des Anspruchs 1 gelöst. In den abhängigen Ansprüchen sind vorteilhafte Weiterbildungen der Erfindung angegeben.

Das erfindungsgemässe Umrichterkühlsystem zur Kühlung mittels eines Kühlfluids umfasst einen Wärmetauscher und einen parallel zu dem Wärmetauscher vorgesehenen Kühlfluidbypasspfad, wobei ein der Regulierung der Kühlfluidmenge dienendes Regulierungsventil einen ersten Verbindungspunkt bildet, an dem der Kühlfluidbypasspfad mit dem Wärmetauscher verbunden ist. Desweiteren ist der Kühlfluidbypasspfad mit dem Wärmetauscher an einem zweiten Verbindungspunkt verbunden. Zudem ist eine Pumpeinheit zur Zirkulation des Kühlfluids vorgesehen, wobei eine Ausgangsseite der Pumpeinheit mit dem ersten Verbindungspunkt verbunden ist. Ferner umfasst das Umrichterkühlsystem einen Filterpfad, der an einem dritten Verbindungspunkt mit einer Eingangsseite der Pumpeinheit verbunden ist und der mit dem zweiten Verbindungspunkt verbunden ist, wobei im Filterpfad eine Filtereinheit vorgesehen ist. Darüber hinaus ist ein Kühlfluidzulaufpfad vorgesehen, der mit dem dritten Verbindungspunkt verbunden ist, und zudem ist ein Kühlfluidablaufpfad vorgesehen, der mit dem vierten Verbindungspunkt verbunden ist, wobei im Kühlfluidzulaufpfad und/oder im Kühlfluidablaufpfad eine Temperaturerfassungseinheit und eine Druckerfassungseinheit vorgesehen sind. Aufgrund der vorstehenden Merkmale ist das erfindungsgemässe Umrichterkühlsystem äusserst einfach und robust aufgebaut. Beispielsweise lassen sich mit Hilfe der Temperaturerfassungseinheit und eine Druckerfassungseinheit die diesbezüglichen Grössen problemlos überwachen, so dass Temperatur- und Druckschwankungen frühzeitig erkannt werden können und geeignete Massnahmen, insbesondere über das Regulierungsventil, eingeleitet werden können. Der Wartungsaufwand des erfindungsgemässen Umrichterkühlsystems ist deshalb sehr gering, wodurch die laufenden Kosten tief gehalten werden können. Nach der Erfindung ist auch eine Kühlfluidleckageauffangeinrichtung vorgesehen, die einen Leckagedetektor aufweist. Die Kühlfluidleckageauffangeinrichtung dient vorteilhaft dem Auffangen von Kühlfluidtropfen bei eventuell auftretenden unerwünschten Leckagen, wobei der vorstehend genannte Leckagedetektor die aufgrund von Leckagen ausgetretene Kühlfluidmenge detektiert.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnung

Es zeigt:

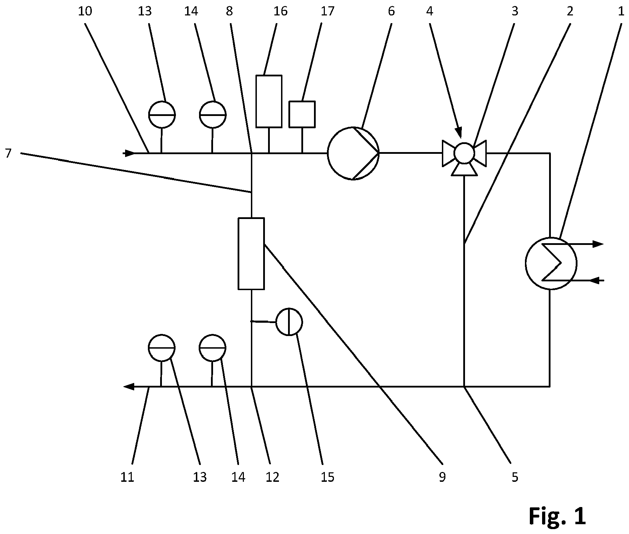

- Fig. 1: eine Ausführungsform eines erfindungsgemässen Umrichterkühlsystems.

Die in der Zeichnung verwendeten Bezugszeichen und deren Bedeutung sind in der Bezugszeichenliste zusammengefasst aufgelistet. Grundsätzlich sind in der Figur gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

Fig. 1 zeigt eine Ausführungsform eines erfindungsgemässen Umrichterkühlsystems. Das Umrichterkühlsystem dient der Kühlung von Leistungshalbleiterschaltern und weiteren Leistungselektronikbauteilen einer oder mehrerer Umrichterschaltungen mittels eines zirkulierenden Kühlfluids, wobei als Kühlfluid deionisiertes bzw. entmineralisiertes Wasser eingesetzt wird, welches eine äusserst geringe elektrische Leitfähigkeit aufweist. Die Leistungshalbleiterschalter werden üblicherweise über Kühlelemente gekühlt, durch das dann das Kühlfluid strömt. Als Kühlelemente werden beispielsweise Kühldosen verwendet, die an den Fluidkreislauf des Umrichterkühlsystem angeschlossen werden, welches dazu, wie in Fig. 1 dargestellt, einen Kühlfluidzulaufpfad 10 und einen im Kühlfluidablaufpfad 11 aufweist. Über den Kühlfluidzulaufpfad 10 strömt zu kühlendes Kühlfluid in das Umrichterkühlsystem, was durch die entsprechende Pfeilung angedeutet ist. Über den Kühlfluidablaufpfad 11 strömt durch das Umrichterkühlsystem gekühltes Kühlfluid aus dem Umrichterkühlsystem, was durch die entsprechende Pfeilung in Fig. 1 gezeigt ist.

Gemäss Fig. 1 umfasst das Umrichterkühlsystem einen Wärmetauscher 1 und einen parallel zu dem Wärmetauscher 1 vorgesehenen Kühlfluidbypasspfad 2, wobei ein der Regulierung der Kühlfluidmenge dienendes Regulierungsventil 3 einen ersten Verbindungspunkt 4 bildet, an dem der Kühlfluidbypasspfad 2 mit dem Wärmetauscher 1 verbunden ist, und wobei der Kühlfluidbypasspfad 2 mit dem Wärmetauscher 1 an einem zweiten Verbindungspunkt 5 verbunden ist. Vorteilhaft ermöglicht das Regulierungsventil 3 eine einstellbare Durchflussmenge durch den Wärmetauscher 1 als auch durch den Kühlfluidbypasspfad 2. Kondensationsbildung, beispielsweise an Leitungen, kann somit vermieden werden, da über die Durchflussmenge des Kühlfluids durch den Wärmetauscher 1 die Temperatur des Kühlfluids beeinflusst werden kann.

Gemäss Fig. 1 ist eine Pumpeinheit 6 zur Zirkulation des Kühlfluids vorgesehen, wobei eine Ausgangsseite der Pumpeinheit 6 mit dem ersten Verbindungspunkt 4 verbunden ist. Ferner umfasst die Umrichtereinheit einen Filterpfad 7, der an einem dritten Verbindungspunkt 8 mit einer Eingangsseite der Pumpeinheit 6 verbunden ist und der mit dem zweiten Verbindungspunkt 5 verbunden ist, wobei im Filterpfad 7 eine Filtereinheit 9 vorgesehen ist. Vorzugsweise umfasst die Filtereinheit 9 ein Deionisationsfilter, der der Deionisierung bzw. Entmineralisierung des Kühlfluids dient, um die elektrische Leitfähigkeit des zirkulierenden Kühlfluids im Umrichterkühlsystem stets gering zu halten. Der bereits eingangs erwähnte Kühlfluidzulaufpfad 10 ist mit dem dritten Verbindungspunkt 8 verbunden und der Kühlfluidablaufpfad 11 ist mit dem vierten Verbindungspunkt 12 verbunden. Allgemein sind im Kühlfluidzulaufpfad 10 und/oder im Kühlfluidablaufpfad 11 eine Temperaturerfassungseinheit 13 und eine Druckerfassungseinheit 14 vorgesehen. Gemäss der Ausführungsform nach Fig. 1 ist beispielhaft sowohl im Kühlfluidzulaufpfad 10 als auch im Kühlfluidablaufpfad 11 jeweils eine Temperaturerfassungseinheit 13 und eine Druckerfassungseinheit 14 vorgesehen. Insgesamt ist das Umrichterkühlsystem nach der Erfindung äusserst einfach und robust aufgebaut. Die Temperaturerfassungseinheit 13 und eine Druckerfassungseinheit 14 ermöglicht eine einfache und problemloses Temperatur- und Drucküberwachung. Ein Druckabfall kann beispielsweise auf eine Leckage und/oder auf eine fehlerhafte Pumpeinheit 6 hindeuten. Ein Druckanstieg wiederum kann zum Beispiel auf einen verstopften Kühlfluidpfad und/oder auf eine fehlerhafte Pumpeinheit 6 hindeuten. Gegebenenfalls auftretende unerwünschte Temperatur- und Druckschwankungen können daher vorteilhaft frühzeitig erkannt werden. Das Regulierungsventil 3, über welches sich die Durchflussmenge durch den Wärmetauscher 1 einstellen lässt, ermöglicht dabei schlussendlich eine Einstellung der Temperatur des Kühlfluids. Ferner ergibt sich ein sehr geringer Wartungsaufwand des erfindungsgemässen Umrichterkühlsystems, so dass die laufenden Kosten des Umrichterkühlsystems vorteilhaft klein gehalten werden können.

Allgemein ist im Kühlfluidzulaufpfad 10 und/oder im Kühlfluidablaufpfad 11 vorzugsweise zusätzlich eine Kühlfluiddurchflusserfassungseinheit vorgesehen, die es ermöglicht die Durchflussmenge im zugehörigen Pfad zu detektieren. Eine solche Kühlfluiddurchflusserfassungseinheit ist in der Ausführungsform gemäss Fig. 1 der Übersichtlichkeit halber nicht dargestellt.

Vorzugsweise ist im Filterpfad 7, wie in Fig. 1 beispielhaft gezeigt, zusätzlich eine Leitfähigkeitserfassungseinheit 15 vorgesehen, die es ermöglicht die elektrische Leitfähigkeit des Kühlfluids zu ermitteln. Alternativ ist es auch denkbar, dass an der Ausgangsseite oder an der Eingangsseite der Pumpeinheit 6 eine Leitfähigkeitserfassungseinheit 15 vorgesehen ist. Als weitere Alternative ist es denkbar, dass im Kühlfluidzulaufpfad 10 oder im Kühlfluidablaufpfad 11 eine Leitfähigkeitserfassungseinheit 15 vorgesehen ist.

In bevorzugter Weise ist bei dem Umrichterkühlsystem eine Kühlfluidleckageauffangeinrichtung vorgesehen ist, die einen Leckagedetektor aufweist. Eine solche Kühlfluidleckageauffangeinrichtung ist in der Ausführungsform gemäss Fig. 1 der Übersichtlichkeit halber nicht dargestellt. Eine denkbare Ausführungsform einer derartigen Kühlfluidleckageauffangeinrichtung ist ein Auffangbehälter, der sich im wesentlichen unterhalb der Komponenten und Elemente des Umrichterkühlsystems erstreckt, um Kühlfluidtropfen bei eventuell auftretenden unerwünschten Leckagen aufzufangen. Der vorstehend genannte Leckagedetektor detektiert vorteilhaft die aufgrund von Leckagen ausgetretene Kühlfluidmenge.

Gemäss Fig. 1 ist an der Ausgangsseite oder an der Eingangsseite der Pumpeinheit 6 ein Ausgleichsbehälter 16 vorgesehen. Der Ausgleichsbehälter dient vorteilhaft der Aufnahme von Kühlfluid, falls sich dieses beispielsweise aufgrund eines Temperaturanstiegs ausdehnt. Ferner dient der Ausgleichsbehälter 16 mit Vorteil aus Kühlfluidreservoir. An der Ausgangsseite oder an der Eingangsseite der Pumpeinheit 6 kann eine Entlüftungseinheit 17 vorgesehen sein, die das kontrollierte Entweichen von Gas im Falle von Gasbildung des Kühlfluids und/oder von Luft im Umrichterkühlsystem ermöglicht.

### Bezugszeichenliste

- 1: Wärmetauscher
- 2: Kühlfluidbypasspfad
- 3: Regulierungsventil
- 4: erster Verbindungspunkt
- 5: zweiter Verbindungspunkt
- 6: Pumpeinheit
- 7: Filterpfad
- 8: dritter Verbindungspunkt
- 9: Filtereinheit
- 10: Kühlfluidzulaufpfad
- 11: Kühlfluidablaufpfad
- 12: vierter Verbindungspunkt
- 13: Temperaturerfassungseinheit
- 14: Druckerfassungseinheit
- 15: Leitfähigkeitserfassungseinheit
- 16: Ausgleichsbehälter
- 17: Entlüftungseinheit

## Patentansprüche

1. Umrichterkühlsystem zur Kühlung mittels eines Kühlfluids, mit einem Wärmetauscher (1) und einem parallel zu dem Wärmetauscher (1) vorgesehenen Kühlfluidbypasspfad (2), wobei ein der Regulierung der Kühlfluidmenge dienendes Regulierungsventil (3) einen ersten Verbindungspunkt (4) bildet, an dem der Kühlfluidbypasspfad (2) mit dem Wärmetauscher (1) verbunden ist, und wobei der Kühlfluidbypasspfad (2) mit dem Wärmetauscher (1) an einem zweiten Verbindungspunkt (5) verbunden ist,
mit einer Pumpeinheit (6) zur Zirkulation des Kühlfluids, wobei eine Ausgangsseite der Pumpeinheit (6) mit dem ersten Verbindungspunkt (4) verbunden ist,
mit einem Filterpfad (7), der an einem dritten Verbindungspunkt (8) mit einer Eingangsseite der Pumpeinheit (6) verbunden ist und der mit dem zweiten Verbindungspunkt (5) verbunden ist, wobei im Filterpfad (7) eine Filtereinheit (9) vorgesehen ist, mit einem Kühlfluidzulaufpfad (10), der mit dem dritten Verbindungspunkt (8) verbunden ist,
mit einem Kühlfluidablaufpfad (11), der mit dem vierten Verbindungspunkt (12) verbunden ist,
wobei im Kühlfluidzulaufpfad (10) und/oder im Kühlfluidablaufpfad (11) eine Temperaturerfassungseinheit (13) und eine Druckerfassungseinheit (14) vorgesehen sind, und wobei eine Kühlfluidleckageauffangeinrichtung vorgesehen ist, die einen Leckagedetektor aufweist.

2. Umrichterkühlsystem nach Anspruch 1, **dadurch gekennzeichnet, dass** im Kühlfluidzulaufpfad (10) und/oder im Kühlfluidablaufpfad (11) zusätzlich eine Kühlfluiddurchflusserfassungseinheit vorgesehen ist.

3. Umrichterkühlsystem nach Anspruch 1 oder 2, **dadurch gekennzeichnet, dass** im Filterpfad (7) zusätzlich eine Leitfähigkeitserfassungseinheit (15) vorgesehen ist.

4. Umrichterkühlsystem nach Anspruch 1 oder 2, **dadurch gekennzeichnet, dass** an der Ausgangsseite oder an der Eingangsseite der Pumpeinheit (6) eine Leitfähigkeitserfassungseinheit (15) vorgesehen ist.

5. Umrichterkühlsystem nach Anspruch 1 oder 2, **dadurch gekennzeichnet, dass** im Kühlfluidzulaufpfad (10) oder im Kühlfluidablaufpfad (11) eine Leitfähigkeitserfassungseinheit (15) vorgesehen ist.

6. Umrichterkühlsystem nach einem der Ansprüche 1 bis 5, **dadurch gekennzeichnet, dass** die Filtereinheit (9) ein Deionisationsfilter umfasst.

7. Umrichterkühlsystem nach einem der Ansprüche 1 bis 6, **dadurch gekennzeichnet, dass** an der Ausgangsseite oder an der Eingangsseite der Pumpeinheit (6) ein Ausgleichsbehälter (16) vorgesehen ist.

8. Umrichterkühlsystem nach einem der Ansprüche 1 bis 7, **dadurch gekennzeichnet, dass** an der Ausgangsseite oder an der Eingangsseite der Pumpeinheit (6) eine Entlüftungseinheit (17) vorgesehen ist.
